# FASCICULE DE BREVET EUROPEEN

(11) **EP 2 203 876 B1**
(45) Date de publication et mention de la délivrance du brevet: **14.01.2015**
(21) Numéro de dépôt: 08870419.2
(22) Date de dépôt: 13.10.2008
(51) Int. Cl.: G06K 19/077

(54) **SUPPORT DE DISPOSITIF D'IDENTIFICATION RADIOFRÉQUENCE RENFORCÉ ET SON PROCÉDÉ DE FABRICATION**
VERSTÄRKTET RADIOFREQUENZ IDENTIFIKATIONSVORRICHTUNG TRÄGER UND SEIN HERSTELLUNGSVERFAHREN
REINFORCED SUBSTRATE FOR RADIOFREQUENCY IDENTIFICATION DEVICE AND METHOD FOR MAKING SAME

(30) Priorité: 11.10.2007 FR 0707143
(43) Date de publication de la demande: 07.07.2010
(73) Titulaire: ASK S.A., 06560 Valbonne (FR)
(72) Inventeur: MAZABRAUD, Olivier, 06600 Antibes (FR); HALOPE, Christophe, 06400 Cannes (FR)
(86) Numéro de dépôt international: PCT/FR2008/001434
(87) Numéro de publication internationale: WO 2009/087295

(56) Documents cités:
- WO-A-01/75772
- WO-A-2004/100063
- WO-A-2006/077339
- FR-A- 2 787 609
- US-B1- 6 404 643

## Description

### Domaine technique

La présente invention concerne les dispositifs d'identification radiofréquence destinés à être intégrés à des objets tels que des documents de sécurité et concerne en particulier un support de dispositif d'identification radiofréquence renforcé pour passeport et son procédé de fabrication.

### Etat de la technique

Les dispositifs d'identification radiofréquence (RFID) sans contact sont de plus en plus utilisés pour l'identification des personnes circulant dans des zones à accès contrôlé ou transitant d'une zone à une autre. Un dispositif RFID sans contact est un dispositif constitué d'une antenne et d'une puce connectée aux bornes de l'antenne. La puce n'est généralement pas alimentée et reçoit son énergie par couplage électromagnétique entre l'antenne du lecteur et l'antenne du dispositif RFID, des informations sont échangées entre le dispositif RFID et le lecteur et en particulier les informations stockées dans la puce qui ont trait à l'identification du possesseur de l'objet sur lequel se trouve le dispositif RFID et son autorisation à pénétrer dans une zone à accès contrôlé.

Ainsi, les passeports peuvent incorporer des dispositifs RFID pour l'identification du possesseur du passeport. La mémoire de la puce contient des informations telles que l'identité du possesseur du passeport, son pays d'origine, sa nationalité, les visas des différents pays visités, les dates d'entrée, les restrictions de circulation, les éléments biométriques, etc. Le dispositif RFID se trouve généralement incorporé dans le plat de couverture inférieur du passeport. Une antenne est alors réalisée par impression d'encre chargée en particules conductrices sur le plat inférieur renforcé de la couverture du passeport. La puce est ensuite connectée par collage aux bornes de connexion de l'antenne. Ensuite, la page de garde du cahier des pages du passeport est contrecollée au verso du plat supérieur renforcé.

Le dispositif RFID peut également être fabriqué indépendamment du passeport pour être incorporé ensuite par collage entre la couverture et la page de garde inférieure par exemple du passeport. Le dispositif RFID comprenant l'antenne et la puce connectées ensemble est intégré alors à un « inlay » en papier, en plastique ou autre.

Des dispositifs RFID ont été développés également avec une puce encapsulée plutôt qu'une puce nue, appelé communément module de circuit intégré. Les récents développements pour réduire la taille de ces modules a permis en effet leur intégration dans les passeports sans augmentation de l'épaisseur de celui-ci ni de la rigidité.

Le problème de fabrication d'un support de dispositif RFID intégrant un module réside dans la connexion du module sur l'antenne. En effet, les connexions traditionnelles telles que la soudure par exemple, utilisées pour connecter les modules sur les antennes cuivre ne sont pas applicables à des antennes imprimées. La connexion du module sur l'antenne est réalisée entre les plots de connexion de l'antenne du support d'antenne et les plots de connexion du module. Cette connexion se fait sur une petite surface par conséquent elle doit être fiable et solide. Cette connexion est réalisée grâce à de la colle conductrice dans le cas d'une antenne en encre conductrice. La réalisation d'une telle connexion nécessite les étapes de fabrication suivantes :
- impression d'une antenne comportant des plots de connexion sur un support,
- Dépôt des plots de colle conductrice sur les plots d'antenne,
- mise en place du module électronique sur les plots de colle conductrice,
- réticulation de la colle conductrice par passage dans un four.

Ensuite, l'étape classique de lamination des différentes couches constitutives de la carte est effectuée par pressage à chaud, en général le corps de carte inférieur et supérieur de part et d'autre du support d'antenne.

Une telle connexion présente des inconvénients. Lors de la pose de la colle conductrice des courts circuit avec le module risquent de se produire. De plus, les plots de colle conductrice durcissent lors de la réticulation sont susceptibles de fissurer les plots de connexion de l'antenne par la pression exercée lors de l'étape de lamination ou bien lors des coups et impacts exercés sur le passeport. Le risque final étant alors de rompre le contact électrique entre l'antenne et le module de circuit intégré et donc d'endommager définitivement le dispositif d'identification radiofréquence.

L'application WO 2006/077339 A divulgue un procédé de fabrication d'un dispositif d'identification radiofréquence par lamination.

### Exposé de l'invention

Le but de l'invention est de remédier à ces inconvénients en proposant un procédé de fabrication d'un support de dispositif d'identification radiofréquence permettant d'assurer une connexion fiable entre le module de circuit intégré et l'antenne.

Un autre but de l'invention est de fournir un livret d'identité tel qu'un passeport intégrant un tel dispositif d'identification radiofréquence sans marque visible de la puce sur l'extérieur de la couverture.

L'objet de l'invention est donc un procédé de fabrication d'un dispositif d'identification radiofréquence (RFID), le dispositif comprenant une antenne et une puce connectée à l'antenne, le procédé comprenant les étapes suivantes :
- imprimer une antenne comportant des plots de connexion sur un support en papier ou en papier synthétique,
- déposer de la matière diélectrique adhésive entre les plots de connexion de l'antenne,
- positionner un module de circuit intégré sur le support, le module comportant des plages de contact et la puce connectée aux plages de contact à l'intérieur d'une encapsulation du module, de manière à ce que les plages de contact du module soient en regard des plots de connexion de l'antenne,
- déposer sur le support une couche de thermoplastique et une couche de papier ou de papier synthétique, les deux couches étant munies d'une cavité à l'endroit de l'encapsulation du module,
- laminer ensemble les trois couches, la couche de support d'antenne, la couche de thermoplastique et la couche de papier ou de papier synthétique de façon à relier électriquement le module à l'antenne et d'agglomérer les couches ensemble.

### Description brève des figures

Les buts, objets et caractéristiques de l'invention apparaîtront plus clairement à la lecture de la description qui suit faite en référence aux dessins dans lesquels :
La figure 1 représente une coupe du module électronique,
La figure 2 représente les différentes couches constitutives du support de dispositif RFID avant lamination,
La figure 3 représente une coupe du support de dispositif RFID.

### Description détaillée de l'invention

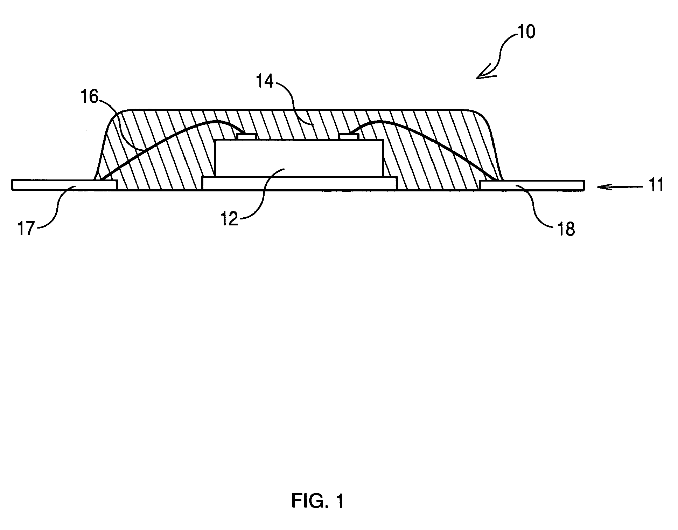

Selon la figure 1, le module de circuit intégré comporte une puce 12, au moins deux plages de connexion 17 et 18. Les connexions entre la puce et les plages 17 et 18 sont réalisées par des fils conducteur ou câbles de connexions très petits, appelés « wire bonding » en anglais. La puce 12 et les fils sont encapsulés dans une résine de protection 14 à base d'un matériau résistant et ne conduisant pas l'électricité. L'encapsulation 14 est en quelque sorte une coque rigide qui vient englober la puce et son câblage de façon à la rendre moins fragile et davantage manipulable. L'encapsulation a une épaisseur comprise entre 200 et 240 *µ*m. Le module présente ainsi sur sa face supérieure une surface plane correspondant à la partie supérieure de l'encapsulation 14 et sur sa face inférieure des plages de contact 17 et 18 destinées à venir se connecter à un circuit. Les plages 17 et 18 sont faites d'un matériau conducteur tel que de l'aluminium et leur épaisseur est comprise entre 70 et 100 *µ*m.

Selon la première étape du procédé de fabrication, une antenne est réalisée sur une couche de support 20. L'antenne comporte un ensemble de une ou plusieurs spires. Les spires sont réalisées par impression de type sérigraphie, flexographie, héliogravure, offset ou jet d'encre à partir d'encre conductrice de type encre époxy chargée de particules conductrices telles que par exemple d'argent ou d'or ou à partir d'un polymère conducteur. La couche de support 20 est en matériau qui ne flue pas tel que du papier ou du papier synthétique. Le papier est composé de fibres végétales réduites en pâte et a par conséquent une structure fibreuse. L'âme du papier a tendance à se délaminer lorsqu'elle est soumise à des contraintes de cisaillement, tandis que le papier synthétique, non fibreux a une structure microporeuse et possède une faible densité. Comme le papier, le papier synthétique facilite l'opération de lamination réalisée à des températures de l'ordre de 160°C, puisqu'il est stable à ces températures contrairement aux matériaux thermoplastiques tel que le PVC ou le PETG, il ne flue pas. Le papier synthétique utilisé est constitué d'une seule couche non orientée d'un polymère tel que du polyéthylène ou du polypropylène chargée en charges minérales entre 40 et 80%. Sa composition lui confère une faible densité de l'ordre de 0,57 g/cm³ grâce à son réseau microporeux Préférentiellement l'épaisseur de la couche de support est comprise entre 140 et 180 *µ*m.

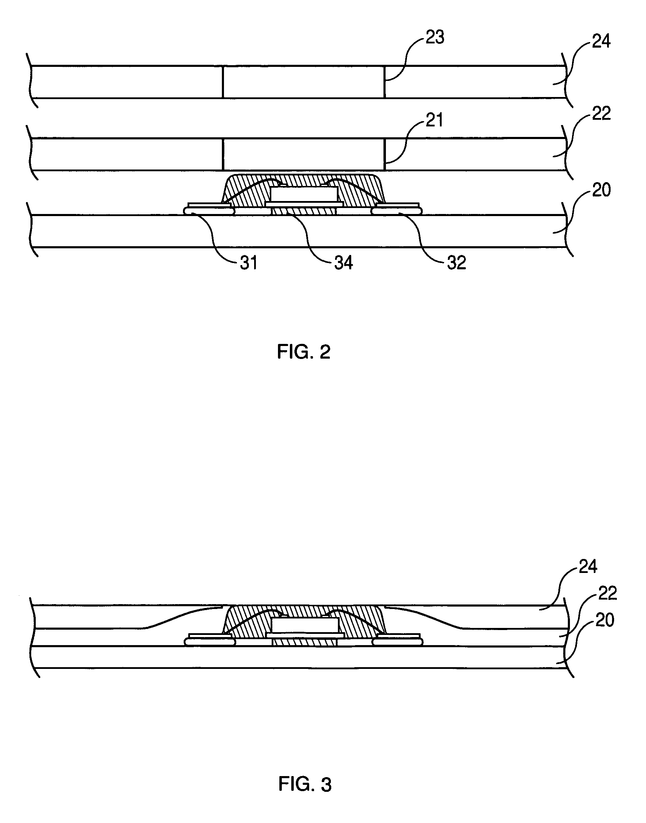

Le module 10 représenté sur la figure 2 est destiné à venir se connecter à l'antenne sur des plots de connexion. Dans le cadre de l'invention seuls deux plots de connexion 31 et 32 suffisent pour connecter le module. Les plots de connexion 31 et 32 sont la continuité de l'antenne, par conséquent ils sont dans le prolongement des spires de l'antenne et sont en général du même matériau que l'antenne. Les plots de connexion sont donc également réalisés par impression de type sérigraphie, flexographie, héliogravure, offset ou jet d'encre à partir d'encre conductrice de type encre époxy chargée de particules conductrices telles que par exemple d'argent ou d'or ou à partir d'un polymère conducteur. L'épaisseur des plots de connexion est comprise entre 5 et 10 *µ*m. L'encre utilisée dans la fabrication des plots de connexion est flexible et non élastique. Il est possible donc que l'encre utilisée pour les plots d'antenne soit différente de l'encre utilisée pour fabriquer le reste de l'antenne.

Le module représenté sur la figure 2 est collé sur la couche de support d'antenne 20 grâce à de la matière adhésive 34 de façon à ce que les plages de contact 17 et 18 du module soient en regard des plots de connexion 31 et 32 de l'antenne. Le module est déposé sur la couche du support d'antenne une fois que l'encre constituant les plots de connexion est sèche et que la matière adhésive est déposée. Le collage du module sur la couche du support d'antenne est nécessaire pour maintenir et fixer le module en position pendant toute la durée du procédé de fabrication. La matière adhésive utilisée est une colle qui scelle le module à la couche de support 20. On utilise une colle de type cyanocrylate. Il est également possible d'utiliser une colle « hot-melt » en film utilisée dans les cartes et qui est placée sous le module avant son insertion dans la carte. Ce collage ne sert pas à la connexion électrique entre le support et l'antenne.

Les différentes couches constitutives du support de dispositif RFID sont ensuite mises en place sur le support d'antenne pour l'étape de lamination. Une première couche 22 en thermoplastique est positionnée directement sur la couche du support d'antenne 20. Le thermoplastique utilisé pour la couche 22 est préférentiellement du polychlorure de vinyle (PVC), mais peut être aussi du polyester (PET, PETG), du polypropylène (PP), du polycarbonate (PC), de l'acrylonitrile-butadiène-styrène (ABS) ou un film polyuréthane (PU). L'épaisseur de la couche de thermoplastique 22 est comprise entre 100 et 160 *µ*m. La couche 22 comporte une cavité 21 dont les dimensions sont voisines des dimensions de la surface plane de la partie supérieure de la partie encapsulée du module. Ainsi, les bords de la cavité épousent les bords de la partie encapsulée du module. De cette façon, lorsque la couche 22 est en place sur la couche du support d'antenne 20, le module 10 se trouve dans la cavité 21. Une seconde couche 24 est positionnée sur la première couche 22. La couche 24 est en papier synthétique ou en papier comme décrit pour la couche du support d'antenne 20. La couche 24 comporte également une cavité 23 de préférence de la même taille que la cavité 21. Lorsque toutes les couches sont mises en place pour l'étape de lamination, les cavités 21 et 23 se superposent.

La dernière étape du procédé de fabrication du support de dispositif RFID consiste à laminer ensemble les 3 couches, la couche du support d'antenne 20, la couche de thermoplastique 22 et la couche 24 de papier ou de papier synthétique. L'étape de lamination consiste à faire subir à l'ensemble des couches une montée en température jusqu'à 150°C et une montée en pression jusqu'à 20 Bars suivies d'une descente en température et d'une descente en pression, le tout selon un ensemble de cycles de durées définies. La descente en température ambiante se fait de préférence à pression constante, la pression est diminuée ensuite. Lors de la lamination le PVC de la couche 22 se fluidifie et emprisonne l'antenne et le module dans la masse. La pression exercée lors de la lamination est dirigée perpendiculairement aux couches et donc perpendiculairement aux plages de contact 17 et 18.

La figure 3 représente en coupe le module et les 3 couches à proximité du module après l'étape de lamination. Lors de l'étape de lamination les trois couches constitutives du support de dispositif RFID diminuent d'épaisseur. Ainsi, les couches 20 et 24 de papier ou de papier synthétique perdent environ 22% de leur épaisseur. Par exemple, une couche 20 ou 24 initialement d'épaisseur 180 *µ*m a une épaisseur de 140 *µ*m après lamination. La couche 22 de thermoplastique diminue de 55% de son épaisseur.

Lors de la lamination une pression est exercée sur l'ensemble du module. Les plages de contact du module appuient sur les plots de connexion de l'antenne créant une déformation des plots de connexion et de la couche de support 20. Cette déformation est sous forme d'une empreinte dont la surface intérieure épouse exactement la surface extérieure des plages de connexion. Ainsi, il existe un contact intime entre les plages de connexion du module et l'encre conductrice des plots de connexion 18 sur une surface de contact maximale. Le matériau formant la couche de support 20 étant déformable et non élastique ainsi que l'encre conductrice des plots, ces deux matériaux n'ont pas tendance à reprendre leur forme d'origine même lorsque la pression cesse d'être exercée.

De plus, lors de la lamination, le thermoplastique ramollit de la couche 22 a épousé complètement les contours du module et les surfaces internes des couches 20 et 24 situées de part et d'autre de la couche 22. Le thermoplastique agit comme une colle entre les couches 20 et 24 de sorte qu'une fois durcit il adhère complètement aux deux couches et au module. Les deux couches 20 et 24 de part et d'autre de la couche de thermoplastique sont contraintes sous l'effet de la pression lors de la lamination et la contrainte exercée est maintenue sur les plages de contact du module de sorte que le contact électrique entre le module et l'antenne est permanent et fiable une fois que le thermoplastique de la couche 24 a durcit. L'étape de lamination permet donc de relier électriquement le module à l'antenne et d'agglomérer les couches 20, 22 et 24 ensemble. Ainsi, par rapport à la mise en place d'une puce nue par le procédé dit de « flip-chip » où la puce est connecté électriquement à l'antenne dès sa mise eh place entre les plots de connexion de l'antenne, l'étape de positionnement du module ne sert qu'à maintenir celui-ci mécaniquement entre les plots de connexion. Le module est connecté électriquement à l'antenne grâce au procédé mis en oeuvre en combinaison avec les matériaux utilisés. En effet, les couches 20 et 22 de papier ou de papier synthétique pincent le module à l'endroit des plages de contact et des plots de connexion de l'antenne et l'effet de pince est maintenu grâce à la couche de thermoplastique 22 qui, une fois refroidit a durcit.

La pression exercée sur la partie encapsulée et rigide du module tend à compresser davantage la partie de la couche de support 20 sur laquelle elle s'appuie donc située juste en dessous. Cet effet tend à rendre le support de dispositif RFID d'épaisseur égale sur toute sa surface. Ainsi, une fois inséré dans la couverture du passeport, l'emplacement du module est invisible.

Le procédé de fabrication selon l'invention procure un dispositif d'identification radiofréquence fiable et résistant. Cet avantage est non négligeable pour l'utilisation du dispositif dans un document sécurisé tel qu'un passeport. En effet, les pages du passeport et par conséquent la couverture supportant le dispositif RFID sont soumis aux impacts des coups de tampon ou apposition des visas ce qui expose la puce électronique à un risque non négligeable de destruction. En outre, la liaison électrique entre le module et l'antenne ne comporte pas d'élément rigide immobilisant le module par rapport à l'antenne tel que soudure ou colle conductrice et de ce fait est plus solide et plus fiable.

## Revendications

1. Procédé de fabrication d'un dispositif d'identification radiofréquence (RFID), ledit dispositif comprenant une antenne et une puce (12) connectée à l'antenne, ledit procédé comprenant les étapes suivantes :
- imprimer une antenne (12) comportant des plots de connexion (17 et 19) sur un support (20) en papier ou en papier synthétique,
- déposer de la matière diélectrique adhésive entre lesdits plots de connexion de l'antenne,
- positionner un module de circuit intégré (10) sur ledit support, ledit module comportant des plages de contact (17, 18) et la puce (12) connectée aux plages de contact à l'intérieur d'une encapsulation (14) du module, de manière à ce que les plages de contact dudit module soient en regard desdits plots de connexion de ladite antenne,
- déposer sur ledit support une couche de thermoplastique (22) et une couche de papier ou de papier synthétique (24), les deux couches (22 et 24) étant munie d'une cavité (21, 23) à l'endroit de l'encapsulation (14) du module (10),
- laminer ensemble les trois couches, la couche de support d'antenne (20), la couche de thermoplastique (22) et la couche de papier ou de papier synthétique (24) de façon à relier électriquement ledit module à ladite antenne et d'agglomérer les couches (20, 22 et 24) ensemble.

2. Procédé de fabrication selon la revendication 1 dans lequel la forme des cavités (21, 23) sont telles qu'elles épousent la forme de l'encapsulation.

3. Procédé selon l'une des revendications 1 ou 2, dans lequel les cavités (21, 23) sont de la même taille.

4. Procédé selon l'une des revendications 1, 2 ou 3, dans lequel une matière diélectrique adhésive (34) est déposée sur ledit support (20) entre les plots de connexion (31, 32) de ladite antenne, avant l'étape de positionnement du module, de façon à maintenir ledit module (10) en position fixe par rapport à la couche de support (20).

5. Procédé selon l'une des revendications précédentes dans lequel la matière adhésive (34), déposée sur la couche de support d'antenne (20) est une colle cyanoacrylate.

6. Procédé selon l'une des revendications précédentes dans lequel l'encre utilisée pour la réalisation des plots d'antenne est flexible.

7. Procédé selon l'une des revendications précédentes dans lequel lors de l'étape de lamination le refroidissement se fait sous pression.

## Patentansprüche

1. Verfahren für die Herstellung einer Hochfrequenz-Identifizierungsvorrichtung (RFID), wobei die Vorrichtung eine Antenne und einen mit der Antenne verbundenen Chip (12) enthält, wobei das Verfahren die folgenden Schritte umfasst:
- Drucken einer Antenne (12), die Verbindungsanschlüsse (17 und 19) auf einem Träger (20) aus Papier oder aus synthetischem Papier aufweist,
- Ablagern von dielektrischem Klebstoffmaterial zwischen den Verbindungsanschlüssen der Antenne,
- Positionieren eines integrierten Schaltungsmoduls (10) auf dem Träger, wobei das Modul Kontaktbereiche (17, 18) und den Chip (12), der mit den Kontaktbereichen innerhalb einer Einkapselung (14) des Moduls verbunden ist, enthält, derart, dass sich die Kontaktbereiche des Moduls gegenüber den Verbindungsanschlüssen der Antenne befinden,
- Ablagern einer thermoplastischen Schicht (22) und einer Schicht aus Papier oder aus synthetischem Papier (24) auf dem Träger, wobei die zwei Schichten (22 und 24) am Ort der Einkapselung (14) des Moduls (10) mit einem Hohlraum (21, 23) versehen sind,
- Laminieren der Gesamtheit der drei Schichten, der Antennenträgerschicht (20), der thermoplastischen Schicht (22) und der Schicht (24) aus Papier oder aus synthetischem Papier, derart, dass das Modul mit der Antenne elektrisch verbunden ist und die Schichten (20, 22 und 24) zusammengepresst werden.

2. Herstellungsverfahren nach Anspruch 1, wobei die Form der Hohlräume (21, 23) derart ist, dass sie sich an die Form der Einkapselung anschmiegen.

3. Verfahren nach einem der Ansprüche 1 oder 2, wobei die Hohlräume (21, 23) die gleiche Größe haben.

4. Verfahren nach einem der Ansprüche 1, 2 oder 3, wobei ein dielektrisches Klebstoffmaterial (34) auf dem Träger (20) zwischen den Verbindungsanschlüssen (31, 32) der Antenne vor der Positionierung des Moduls abgelagert wird, derart, dass das Modul (10) an einer festen Position in Bezug auf die Trägerschicht (20) gehalten wird.

5. Verfahren nach einem der vorhergehenden Ansprüche, wobei das Klebstoffmaterial (34), das auf der Antennenträgerschicht (20) abgelagert wird, ein Cyanoacrylat-Klebstoff ist.

6. Verfahren nach einem der vorhergehenden Ansprüche, wobei die Farbe, die für die Verwirklichung der Antennenanschlüsse verwendet wird, flexibel ist.

7. Verfahren nach einem der vorhergehenden Ansprüche, wobei im Schritt des Laminierens die Kühlung unter Druck erfolgt.

## Claims

1. A method for manufacturing a radio frequency identification device (RFID), said device featuring an antenna and a chip (12) connected to the antenna, said method including the following steps:
- printing an antenna (12) having contacts (17 and 19) on a support (20) made of paper or synthetic paper,
- placing adhesive dielectric material between said contacts of the antenna,
- positioning an integrated circuit module (10) on said support, said module featuring groups of contacts (17, 18) and the chip (12) connected to groups of contacts inside an encapsulation (14) of the module, so that the groups of contacts of said module are opposite said contacts of said antenna,
- placing on said support a thermoplastic layer (22) and a paper or synthetic paper layer (24), the two layers (22 and 24) being provided with a recess (21, 23) at the location of encapsulation (14) of the module (10),
- laminating together the three layers, the antenna support layer (20), the thermoplastic layer (22) and the paper or synthetic paper layer (24) in order to electrically connect said module to said antenna and agglomerate the layers (20, 22 and 24) together.

2. The manufacturing method according to claim 1 in which the shape of recesses (21, 23) is such that they match the encapsulation form.

3. The method according to any of claims 1 or 2, in which the recesses (21, 23) are of the same size.

4. The method according to any one of claims 1, 2 or 3, in which an adhesive dielectric material (34) is placed on said support (20) between the connections (31, 32) of said antenna, before the chip is positioned, so as to maintain said module (10) in a fixed position relative to the support.

5. The method according to any of the previous claims in which the adhesive material (34) applied to the antenna support layer (20) is a cyanoacrylate glue.

6. The method according to any of the previous claims in which the ink used for making the antenna contacts is flexible.

7. The method according to any of the previous claims in which, during the lamination step, the cooling is done under pressure.
